# FASCICULE DE BREVET EUROPEEN

(11) **EP 0 562 904 B1**
(45) Date de publication et mention de la délivrance du brevet: **04.09.1996**
(21) Numéro de dépôt: 93400642.0
(22) Date de dépôt: 12.03.1993
(51) Int. Cl.: H03K 5/13, H03K 19/003

(54) **Procédé et dispositif de réglage de retard à plusieurs gammes**
Verfahren und Vorrichtung zur Regelung einer Verzögerung über mehrere Verzögerungsbereiche
Process and device for adjusting a delay in several ranges

(30) Priorité: 24.03.1992 FR 9203526
(43) Date de publication de la demande: 29.09.1993
(73) Titulaire: BULL S.A., 78430 Louveciennes (FR)
(72) Inventeur: Marbot, Roland, F-78000 Versailles (FR)
(74) Mandataire: Colombe, Michel

(56) Documents cités:
- EP-A- 0 306 662
- EP-A- 0 317 758
- EP-A- 0 347 983
- EP-A- 0 456 231

## Description

L'invention concerne les dispositifs à retard réglable en fonction d'une consigne de retard pouvant être sous la forme d'une grandeur numérique.

Les circuits à retard réglable ont de nombreuses applications et sont notamment utilisés lorsqu'on veut ajuster la phase entre deux signaux logiques. Dans ce cas, le premier de ces signaux est appliqué à l'entrée d'un circuit à retard et la mesure du déphasage entre le signal de sortie et le signal d'entrée sert à commander le réglage du circuit à retard.

L'asservissement de phase peut être réalisé au moyen d'un signal de réglage analogique ou numérique, la solution numérique étant souvent préférée car elle est moins sensible aux perturbations et aux atténuations dues à la transmission des signaux. De plus, dans le cas d'une réalisation sous forme de circuit intégré, elle est moins sensible aux dispersions de fabrication.

Une première solution connue pour réaliser un circuit à retard à commande numérique consiste à utiliser une pluralité de portes élémentaires, par exemple du type inverseur, associées à un système d'interconnexion commandé numériquement et permettant le branchement en cascade d'un nombre variable de portes élémentaires. L'application de ce type de circuit est cependant limitée au cas où il n'est pas nécessaire d'obtenir une précision de réglage du retard inférieure au retard intrinsèque de la porte élémentaire.

Une autre solution connue consiste à utiliser un circuit du type résistance-capacité où la résistance est constituée d'une pluralité de résistances élémentaires branchées sélectivement en parallèle en fonction de la commande numérique. Dans ce cas, le retard est fixé par la constante de temps du circuit. Si toutes les résistances élémentaires ont la même valeur, le retard obtenu est alors inversement proportionnel au nombre de résistances sélectionnées. Or, pour obtenir une précision de réglage constante sur toute la plage de réglage, il est nécessaire que la fonction liant le retard à la grandeur numérique de réglage s'approche le plus possible d'une fonction linéaire. La réponse obtenue par la solution précédente est donc très éloignée de la relation linéaire. Pour s'en rapprocher, il est alors nécessaire de dimensionner les résistances élémentaires à des valeurs bien précises et toutes différentes entre elles. Ce résultat est cependant très difficile à obtenir dans le cas d'une réalisation intégrée. D'autre part, il faudra prévoir un tel circuit pour chaque signal que l'on veut ajuster en phase.

Si par exemple le circuit à retard est destiné à être utilisé dans un circuit verrouillé en phase du type décrit dans la demande de brevet européen publiée sous le numéro 441 684, déposée le 30 janvier 1991 et intitulée "Circuit verrouillé en phase et multiplieur de fréquence en résultant", la solution précédente n'est pas satisfaisante à cause de son encombrement et de sa sensibilité aux dispersions de fabrication.

Une méthode consistant à effectuer une superposition avec pondération et effet intégral du signal d'entrée et d'un signal retardé d'une valeur fixe par rapport au signal d'entrée permet un réglage précis avec la possibilité d'obtenir un retard minimal inférieur au retard intrinsèque des portes élémentaires pour la technologie choisie. En limitant la valeur du retard fixe, cette solution assure en outre avec une bonne approximation une réponse linéaire du retard en fonction de la consigne de retard. La plage de réglage du retard est alors égale à la valeur du retard fixe. Or, pour certaines applications, il est souhaitable de pouvoir régler le retard sur une plage importante. Cependant, si l'on augmente la valeur du retard fixe au-delà d'une certaine valeur dépendant du dimensionnement du circuit de combinaison, la réponse du retard en fonction de la consigne devient de moins en moins linéaire et finit par présenter une discontinuité.

L'invention a pour but de remédier aux inconvénients précédents en proposant une solution permettant à la fois un réglage précis et linéaire avec une bonne approximation avec la possibilité d'obtenir un retard minimal de faible valeur tout en permettant une plage de réglage étendue.

Dans ce but, l'invention a pour objet un procédé pour fournir un signal de sortie présentant un retard par rapport à un signal logique d'entrée, ledit retard étant réglable en fonction d'une consigne de retard, caractérisé en ce qu'il consiste à produire une succession de signaux retardés, par rapport au signal d'entrée, le retard entre un signal retardé et le signal précédent ayant une valeur prédéterminée, à sélectionner l'un desdits signaux retardés et le signal précédent et à effectuer une superposition avec pondération et effet intégral desdits signaux sélectionnés, ladite sélection et ladite pondération étant déterminées en fonction de ladite consigne de retard.

Le procédé selon l'invention définit donc une pluralité de gammes de réglage, le choix d'une gamme déterminée étant effectuée en sélectionnant l'un des signaux retardés et le signal précédent.

Afin d'obtenir un retard variant de façon continue en fonction de la consigne malgré le passage d'une gamme à une autre, le procédé selon l'invention est en outre caractérisé en ce que ladite pondération consiste à affecter aux deux signaux sélectionnés respectivement deux coefficients de pondération complémentaires fonction de ladite consigne de retard et compris entre 0 et une valeur maximale.

L'invention a également pour objet un circuit à retard pour la mise en oeuvre du procédé selon l'invention. Ce circuit est caractérisé en ce qu'il comporte des moyens de sélection pour sélectionner l'un desdits signaux retardés et le signal précédent et des moyens de combinaison pour fournir un signal de combinaison résultant de la superposition avec pondération et effet intégral desdits signaux sélectionnés, lesdits moyens de sélection et de combinaison étant commandés par un circuit de commande en fonction de ladite consigne de retard.

L'invention a également pour objet plusieurs modes de réalisation spécialement conçus pour pouvoir utiliser les technologies ECL et CMOS.

Ces réalisations ainsi que d'autres aspects et avantages de l'invention apparaîtront dans la suite de la description en référence aux figures.
- La figure 1 représente le schéma de principe du circuit à retard conforme à l'invention.
- La figure 2 représente une première variante de réalisation du circuit de la figure 1.
- La figure 3 représente des chronogrammes permettant d'expliquer le fonctionnement du circuit de la figure 2.
- La figure 4 représente le schéma de principe d'une réalisation ECL du circuit à retard selon l'invention.
- Les figures 5 et 6 représentent une réalisation détaillée en technologie ECL.
- La figure 7 représente le schéma de principe d'une réalisation CMOS.
- La figure 8 représente une réalisation détaillée en technologie CMOS.
- La figure 9 représente un circuit de commande du circuit à retard selon l'invention.
- La figure 10 représente des diagrammes pour expliquer le fonctionnement du circuit de commande selon la figure 9.

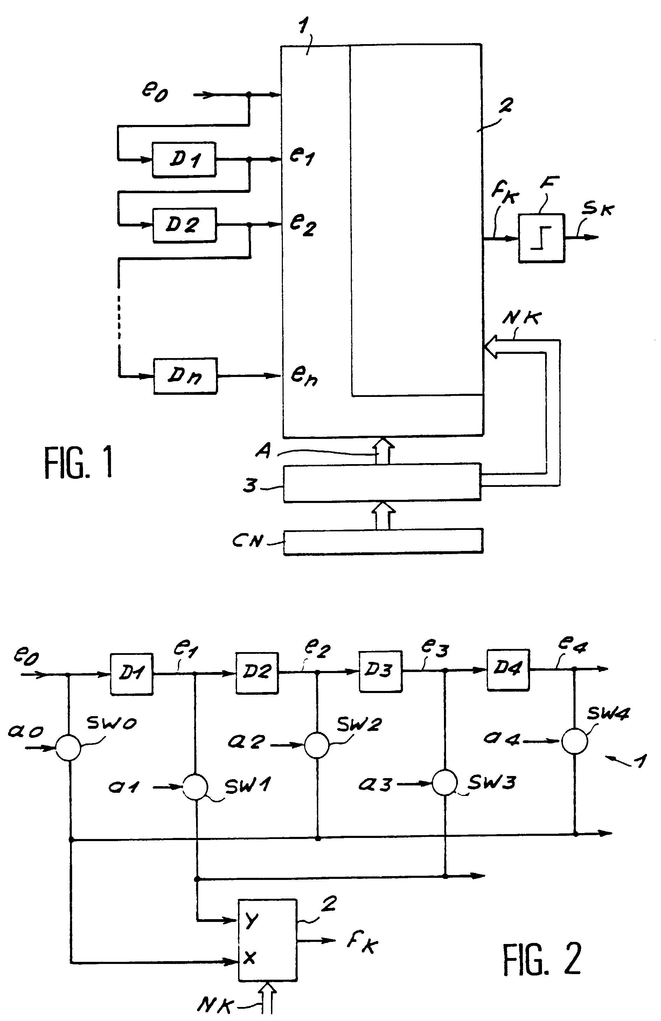

Le circuit à retard selon l'invention est représenté schématiquement à la figure 1. Une pluralité de circuits à retard fixe D1, D2, ..., Dn sont montés en cascade, le premier circuit à retard fixe D1 recevant en entrée un signal d'entrée e₀. Les circuits à retard fixe D1, D2, ..., Dn délivrent en sortie des signaux retardés e₁, e₂, ..., eₙ.

Le signal d'entrée e₀ ainsi que les signaux retardés e₁ à eₙ sont appliqués à l'entrée de moyens de sélection 1 et de combinaison 2 commandés respectivement en fonction de signaux de sélection A et de signaux de pondération NK fournis par un circuit de commande 3. Le circuit de commande 3 reçoit en entrée la consigne de retard CN pouvant prendre la forme d'une grandeur numérique binaire.

Les moyens de combinaison 2 fournissent en sortie un signal de combinaison f_{K} qui est appliqué à l'entrée d'un circuit de mise en forme F dont la sortie fournit le signal logique de sortie s_{K}.

Le circuit de la figure 1 fonctionne de la façon suivante. En fonction de la valeur de la consigne de retard CN, le circuit de commande 3 fournit les signaux A pour sélectionner l'un des signaux retardés ainsi que le signal qui le précède dans la chaîne des circuits à retard fixe D1, ..., Dn. Les signaux de sélection A définissent donc la gamme de réglage nécessitée par la consigne de retard CN. Le circuit de commande 3 fournit d'autre part les signaux de pondération NK en fonction des poids faibles de la consigne de retard CN. Ces signaux NK vont définir les coefficients de pondération appliqués aux moyens de combinaison 2.

La figure 2 représente une première possibilité de disposition des moyens de sélection 1 par rapport aux moyens de combinaison 2. Pour simplifier la suite de l'exposé, le nombre de signaux retardés et de circuits à retard fixe associés sera limité à 4, étant entendu que l'invention ne se limite pas à ce cas particulier et peut être facilement généralisée pour un nombre quelconque de signaux retardés. D'autre part, on utilisera la logique positive et on supposera que les interrupteurs sont ouverts ou fermés selon que les signaux qui les commandent sont respectivement à 0 ou à 1.

Selon la réalisation représentée à la figure 2, les moyens de combinaison sont constitués d'un seul circuit de combinaison 2 comportant deux entrées X et Y destinées à recevoir deux signaux successifs parmi les signaux e₀, ..., e₄. Le circuit de combinaison 2 reçoit les signaux de pondération NK et fournit en sortie.le signal de combinaison f_{K}. L'entrée X du circuit de combinaison 2 est reliée au signal d'entrée e₀ ainsi qu'aux signaux retardés de rang pair e₂, e₄ par l'intermédiaire respectivement des interrupteurs SW0, SW2, SW4, commandés respectivement par les signaux de sélection a₀, a₂, a₄. L'entrée Y du circuit 2 est reliée aux signaux retardés de rang impair e₁, e₃, par l'intermédiaire respectivement des interrupteurs SW1, SW3 commandés respectivement par les signaux de sélection a1, a3.

En fonctionnement, pour une gamme de réglage déterminée en fonction de la consigne de retard CN, le circuit de commande 3 active deux interrupteurs successifs, par exemple SW0 et SW1, de façon à permettre au circuit de combinaison 2 d'effectuer la superposition avec effet intégral et pondération des deux signaux e₀, e₁ sélectionnés.

Pour faciliter les explications qui vont suivre, nous raisonnerons sur des grandeurs normalisées des signaux impliqués et on supposera que les coefficients de pondération affectés aux signaux sélectionnés sont complémentaires et compris entre 0 et 1. Ainsi, le coefficient appliqué au signal reçu par l'entrée X du circuit 2 aura une valeur K variable entre 0 et 1 tandis que celui appliqué au signal reçu par l'entrée Y prendra la valeur 1 - K.

Dans ces conditions, le circuit 2 est conçu pour réaliser la combinaison KX + (1 - K) Y avec intégration par rapport au temps.

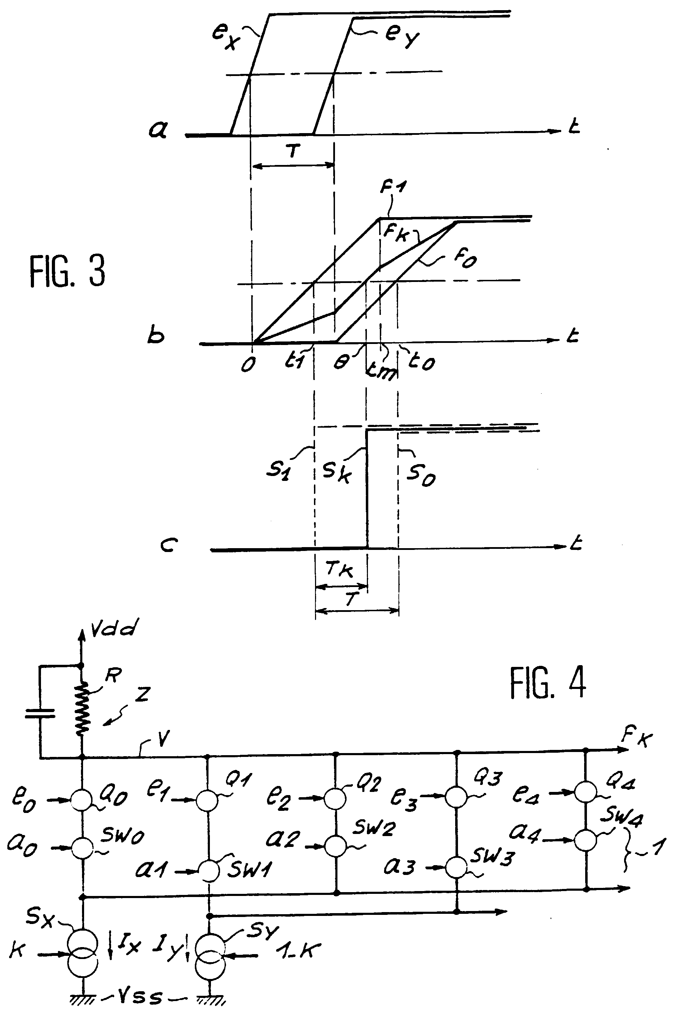

Les chronogrammes représentés à la figure 3 permettent d'expliquer le fonctionnement du circuit de combinaison 2.

Le chronogramme (a) représente les signaux sélectionnés e_{X} et e_{Y} parmi les signaux e₀ à e₄ et appliqués respectivement aux entrées X et Y du circuit 2. Les signaux e_{X}, e_{Y} présentent normalement un front raide de transition entre un premier et un second niveau qui est suivi d'un autre front (non représenté) rétablissant le signal à son premier niveau. En pratique, ce front est défini par l'instant où le signal atteint une valeur de seuil correspondant généralement au niveau intermédiaire entre les niveaux minimum et maximum du signal.

Si l'on suppose par exemple que les signaux de sélection a0 et a1 sont actifs, les signaux e_{X} et e_{Y} seront respectivement les signaux e₀ et e₁. Le signal e_{Y} sera alors identique au signal e₀ mais retardé du retard T défini par le circuit à retard D1.

Le chronogramme (b) représente le signal de combinaison f_{K} pour différentes valeurs du coefficient de pondération K. Bien entendu, la forme des signaux représentés est une représentation simplifiée des signaux que l'on peut obtenir avec des circuits réels. Il convient toutefois de noter que cette représentation n'est pas éloignée de la réalité. En particulier, on observera toujours un palier de saturation car l'intégrale d'une impulsion finit de toute façon par être limitée aux valeurs des potentiels d'alimentation.

Le signal f₁ correspond au cas où K = 1, c'est-à-dire lorsque le coefficient de pondération appliqué au signal e₁ est nul. Ce signal a la forme d'un trapèze dont le front montant débute à l'instant 0 correspondant à l'instant où le signal e₀ atteint la valeur de seuil. Le signal f₁ augmente de façon linéaire jusqu'à l'instant tm où il atteint un palier de saturation.

Le signal f₀ correspond au cas où le coefficient de pondération K appliqué au signal e₀ est nul. Ce signal reproduit le signal f₁ avec le retard T.

Pour des coefficients de pondération différents de ces deux cas extrêmes, le signal de combinaison a l'allure représentée par la courbe f_{K}.

Les signaux f₁ et f₀ atteignent la valeur de seuil respectivement aux instants t1 et t0 tandis que le signal f_{K} atteint ce seuil à l'instant θ. L'écart entre t1 et t0 est égal au retard T. Ainsi, les retards respectivement minimum et maximum du signal de combinaison f_{K} par rapport au signal d'entrée e₀ sont compris entre respectivement t1 et t0. Par conséquent, le retard obtenu dans le cas général aura une valeur θ comprise t1 et t1 + T.

Le chronogramme (c) représente le signal de sortie du circuit de mise en forme F dans chacun des trois cas représentés sur le chronogramme (b). Ainsi, les signaux s₁ et s₀ présentent un front respectivement aux instants t1 et t0. Pour un coefficient K donné, le signal de sortie s_{K} possèdera un front retardé d'une valeur T_{K} par rapport au signal s₁, la valeur T_{K} étant comprise entre 0 et T.

La façon dont le retard θ varie en fonction du coefficient de pondération K dépend essentiellement du temps de transition tm défini ci-dessus et du retard fixe T. Le temps de transition tm définira le retard minimum t1 du signal de sortie s_{K} par rapport au signal d'entrée e₀. Dans le cas parfaitement linéaire tel que représenté, ce retard minimum est égal à la moitié du temps de transition.

Lorsque l'on étudie les variations du retard T_{K} en fonction du coefficient K pour différentes valeurs du temps de transition tm et du retard fixe T, on constate que T doit être inférieur à tm pour éviter toute discontinuité du retard T_{K} en fonction du coefficient de pondération K donc de la consigne de retard. D'autre part, on obtient une réponse parfaitement linéaire de retard T_{K} en fonction de K dès que T est inférieur ou égal à tm/2. Ainsi, pour tm fixé, on obtiendra une réponse linéaire tout en ayant la plus grande plage de réglage lorsque T est égal à tm/2.

Pour une sélection donnée d'un signal retardé et du signal précédent, le retard fixe T détermine la plage de réglage du retard. Aussi, pour une plage déterminée, il sera possible d'obtenir une réponse linéaire en choisissant tm égal 2T. On pourra cependant être amené à choisir un temps de transition inférieur afin de réduire le retard minimal t1 qui dépend directement du temps de transition tm.

D'une façon générale, le choix de T et de tm résultera d'un compromis entre le retard minimal, la plage de réglage pour une gamme choisie et la linéarité du retard par rapport à la consigne de retard.

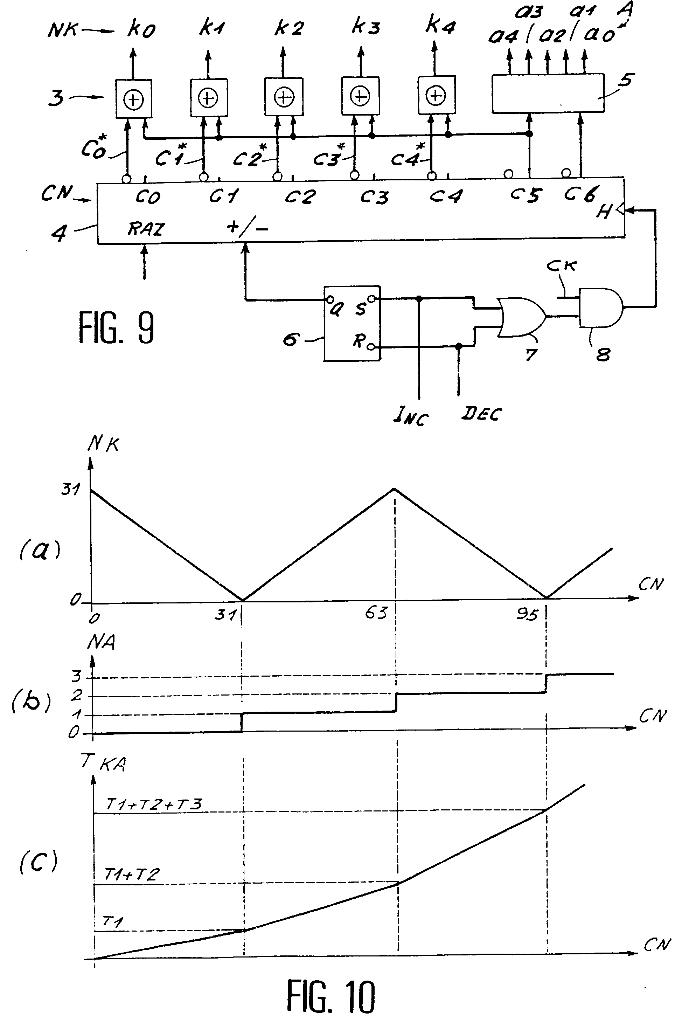

Grâce à la disposition représentée à la figure 2, le passage d'une gamme à une autre n'entraîne aucune discontinuité du réglage du retard en fonction de la consigne si l'on prévoit que le coefficient K varie en fonction de la consigne CN selon une fonction respectivement décroissante ou croissante selon que le signal retardé sélectionné est de rang impair ou pair. Nous verrons ultérieurement en référence aux figures 9 et 10 comment obtenir en pratique ce résultat.

La figure 4 représente un autre schéma de principe des moyens de sélection et de combinaison en vue d'une réalisation en technologie ECL.

Le circuit représenté est alimenté par deux potentiels d'alimentation Vdd et Vss correspondant respectivement à un potentiel positif et la masse. Une impédance Z formée d'une résistance R et d'une capacité en parallèle a une première borne reliée au potentiel positif Vdd et une seconde borne reliée à deux sources de courant Sx et Sy par l'intermédiaire respectivement d'interrupteurs Q0, SW0, Q2, SW2, Q4, SW4 et Q1, SW1, Q3, SW3. Les interrupteurs de même indice pair sont montés en série et reliés à la première source de courant Sx tandis que les interrupteurs de même indice impair sont reliés en série et reliés à la seconde source de courant Sy. Les interrupteurs Q0 à Q4 sont commandés respectivement par les signaux e₀ à e₄ et les interrupteurs SW0 à SW4 sont commandés respectivement par les signaux de sélection a0 à a4. Les sources de courant Sx et Sy sont des sources de courant réglables commandées respectivement par les coefficients de pondération K et 1 - K et fournissent respectivement des courants Ix et Iy complémentaires et proportionnels aux coefficients de pondération correspondants.

Ce montage réalise donc une superposition des courants Ix et Iy dans l'impédance Z dont la capacité est responsable de l'effet d'intégration.

Le potentiel V de la seconde borne constitue la mesure du signal de combinaison f_{K} et la constante de temps de l'impédance Z permettra de définir le temps de transition tm.

Le fonctionnement du circuit de la figure 4 peut être expliqué à l'aide des chronogrammes de la figure 3 en supposant par exemple que les signaux e₀ et e₁ sont sélectionnés.

Initialement, jusqu'à l'instant 0, les signaux e₀ et e₁ étant à 0, le potentiel V est égal à Vdd. Lorsque e₀ passe à 1, l'interrupteur Q0 se ferme et un courant I0 = KI circule dans l'impédance Z. Le potentiel V diminue alors, avec la constante de temps de l'impédance Z, vers la valeur Vdd - KRI pendant une durée égale au retard fixe T. e₁ passe alors à 1, Q1 se ferme et un courant (1 - K)I s'ajoute au courant KI dans l'impédance Z. Le potentiel V continue donc à diminuer vers la valeur Vdd - RI avec la même constante de temps.

Par la suite, e₀ repasse à 0 et Q0 s'ouvre. Le potentiel V remonte alors vers Vdd - (1 - K)RI pendant la durée T avec la même constante de temps. Enfin, e₁ repasse à 0, Q1 s'ouvre et le potentiel V continue à monter vers Vdd.

Le circuit effectue donc la superposition avec effet intégral des grandeurs Ke₀ et (1 - K)e₁. Bien entendu, les signaux f₁, f₀ et f_{K} présentent en réalité des variations plus progressives que celles représentées sur la figure 3(b), notamment au voisinage du palier de saturation. Cette différence ne modifie toutefois pas substantiellement le résultat obtenu si on définit le temps de transition tm comme l'intervalle de temps pendant lequel les signaux f₁ et f₀ varient pratiquement linéairement en fonction du temps.

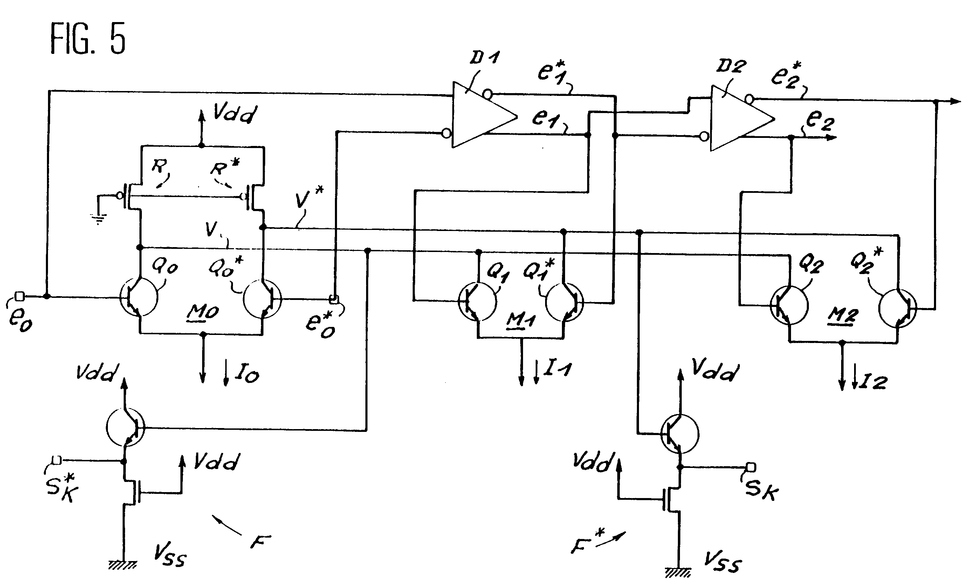

La figure 5 représente une réalisation ECL du circuit de combinaison 2. Ce circuit comporte deux résistances R, R* de même valeur, par exemple réalisées au moyen de transistors MOS, ayant chacune une première borne reliée au potentiel d'alimentation Vdd. Un premier montage différentiel M0 est formé de deux transistors bipolaires Q0, Q0* dont les collecteurs sont reliés respectivement à la deuxième borne des résistances R et R* et dont les émetteurs sont alimentés par un courant I0. Un second montage différentiel M1 identique à M0 est formé des transistors bipolaires Q1 et Q1* dont les collecteurs sont reliés respectivement à la deuxième borne des résistances R et R* et dont les émetteurs sont alimentés par un courant I1.

Le signal d'entrée est un signal différentiel e₀, e₀* commandant les bases des transistors Q0 et Q0*. Le signal différentiel e₀, e₀* est d'autre part appliqué à l'entrée d'un amplificateur différentiel D1 jouant le rôle de circuit à retard fixe. L'amplificateur D1 fournit un signal différentiel retardé e1, e1* commandant les bases des transistors Q1 et Q1*. Le signal différentiel retardé e₁, e₁* est appliqué à l'entrée d'un second amplificateur différentiel D2 servant aussi de circuit à retard fixe. L'amplificateur D2 fournit un second signal différentiel retardé e₂, e₂* commandant les bases des transistors Q2 et Q2* d'un troisième montage différentiel M2 identique à M0 et M1 et branché de la même façon. Les émetteurs des transistors Q2 et Q2* sont alimentés par un courant I2.

La tension différentielle V, V* entre les deuxièmes bornes des résistances R et R* constitue la mesure du signal de combinaison. Deux montages émetteurs-suiveurs F, F* sont commandés par le signal de combinaison différentiel V, V* et fournissent en sortie un signal de sortie différentielle s_{K}, s_{K}*.

On pourra bien sûr prévoir d'autres amplificateurs différentiels et montages différentiels disposés à la suite pour augmenter le nombre de gammes de réglage.

En fonction de la gamme de réglage choisie, seuls deux montages différentiels voisins déterminés seront alimentés en courant, le courant des modules de rang respectivement pair et impair étant proportionnel respectivement à K et 1 - K.

Le fonctionnement du circuit de la figure 5 se déduit aisément de celui de la figure 4 à la différence près que les signaux sont de type différentiel. Il convient de remarquer que l'impédance Z de la figure 4 est formée pour chaque voie de la résistance R ou R* et de l'ensemble des capacités qui sont reliées à la résistance telles que les capacités collecteur-base des transistors bipolaires. Dans le cas où les résistances R et R* sont formés de transistors MOS, il conviendra également de tenir compte des capacités drain-grille de ces transistors.

Contrairement à la réalisation de la figure 2, celles des figures 4 et 5 évitent de procéder à une sélection directe des signaux retardés. Cette particularité permet de réduire le retard minimum à condition que le nombre de gammes ne soit pas trop élevé car la capacité, donc la constante de temps augmente avec le nombre de montage différentiel. Le choix entre les dispositions des figures 2 ou 4 et 5 dépendra donc de l'importance relative que l'on attache au retard minimum et à la plage de réglage. Bien entendu, si le choix se porte sur la disposition de la figure 2, le circuit de combinaison 2 pourra utiliser la solution ECL de la figure 5 avec seulement deux montages différentiels M0 et M1 et des circuits de sélection des signaux différentiels e₀, e₀*, ..., e₄, e₄* à appliquer aux entrées des montages M0 et M1.

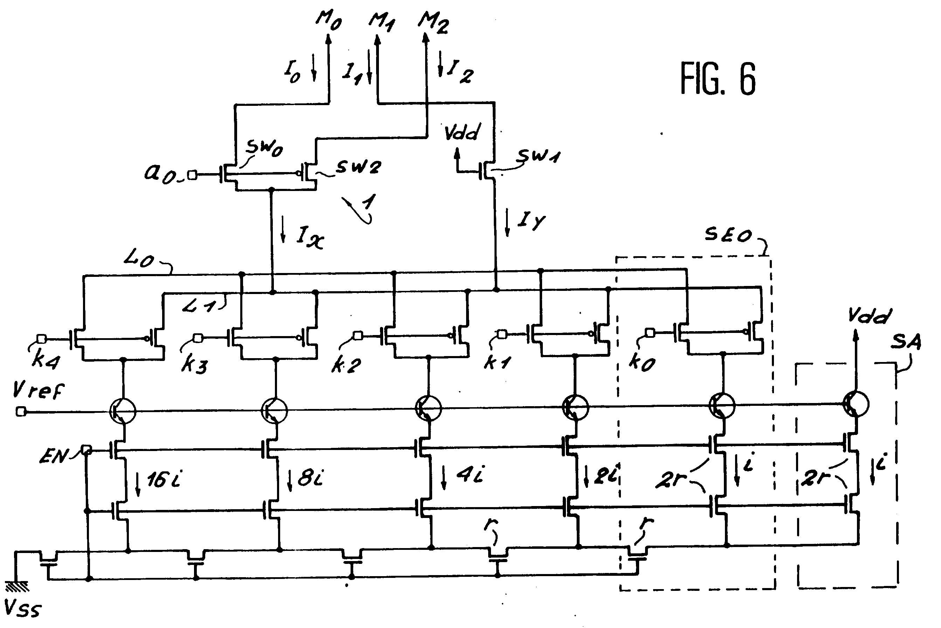

La figure 6 représente un circuit permettant de réaliser les courants variables I0, I1, I2 ainsi que les moyens de sélection, dans le cas particulier où seulement deux gammes de réglage sont prévues.

Selon cette réalisation, le coefficient K est sous la forme d'un nombre binaire NK à cinq bits représentés par les cinq signaux k0 à k4, k0 correspondant au bit de poids faible. Dans ce cas, K peut donc prendre 32 valeurs différentes réparties uniformément entre 0 et 1 (à un coefficient multiplicateur près).

Bien entendu, les réalisations pour un nombre quelconque de bits seront facilement déduites de ce cas particulier.

Le circuit comporte un premier et un second ensemble de résistances respectivement de valeur r et 2r. Les résistances r sont ici réalisées au moyen de transistors MOS à canal n et les résistances 2r sont formées par deux transistors MOS à canal n de même dimension branchés en série. Tous ces transistors MOS ont leur grille polarisée par la tension EN qui les place en régime saturé.

Le circuit comporte un premier sous-ensemble SA comprenant un transistor bipolaire dont le collecteur est relié au potentiel Vdd, dont l'émetteur est relié à une première borne d'une résistance 2r et dont la base reçoit une tension de polarisation Vref.

Un second sous-ensemble SEO comporte un autre transistor bipolaire dont la base reçoit la même tension de polarisation Vref et dont l'émetteur est relié à une première borne d'une autre résistance 2r dont la seconde borne est reliée à la seconde borne de la résistance 2r du sous-ensemble SA ainsi qu'à une première borne d'une résistance r. Le collecteur du transistor bipolaire est relié à deux lignes L0 et L1 par l'intermédiaire respectivement d'un transistor MOS à canal n et d'un transistor MOS à canal p dont les grilles reçoivent le signal k0.

Le circuit comporte quatre autres sous-ensembles (non référencés) identiques à SEO et dont les transistors MOS reçoivent sur leurs grilles respectivement les signaux k1 à k4. Ces quatre sous-ensembles sont montés de la façon indiquée à la figure 6.

La ligne L0 est reliée aux modules M0 et M2 par l'intermédiaire de transistors MOS jouant le rôle des interrupteurs SW0 et SW2. La ligne L1 est reliée au module M1 par l'intermédiaire d'un interrupteur SW1 réalisé au moyen d'un transistor MOS polarisé pour fonctionner en régime saturé.

Il est facile de vérifier que le circuit de la figure 6 délivre des courants Ix et Iy respectivement proportionnels à K et 1 - K. D'autre part, la gamme de réglage sera sélectionnée en fonction d'un seul signal de sélection a0 si les transistors MOS, SW1 et SW2 associés aux modules M0 et M2 sont complémentaires comme représenté sur la figure.

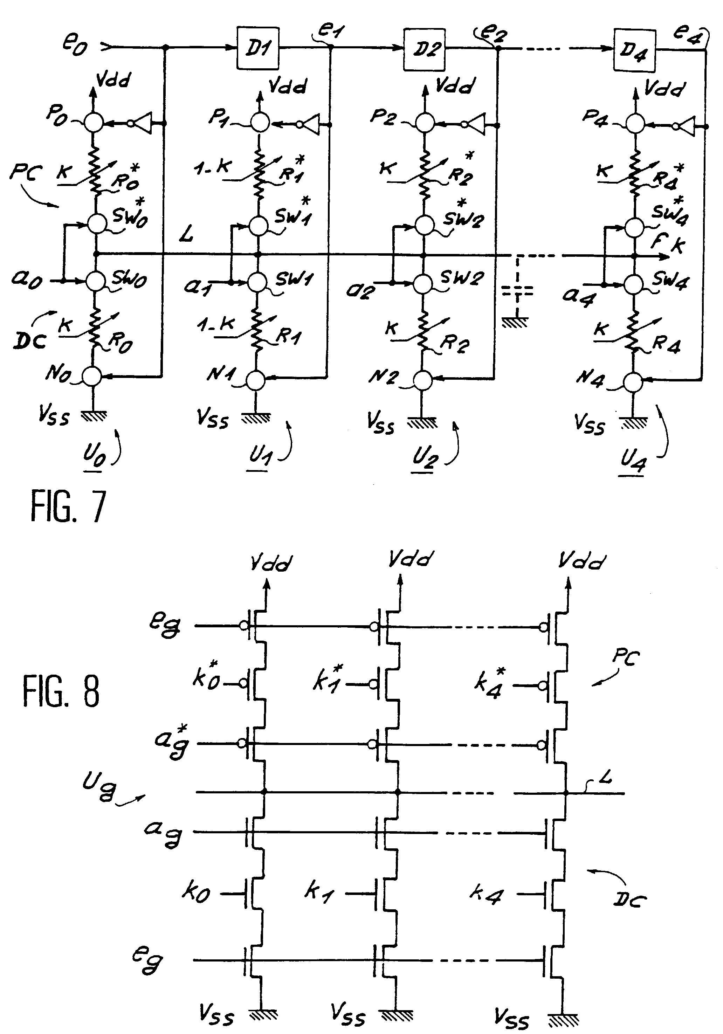

Les figures 7 et 8 concernent une autre réalisation en technologie CMOS du circuit de combinaison 2.

La figure 7 est la représentation schématique d'une réalisation CMOS permettant de faciliter sa compréhension. Le circuit comporte une pluralité de modules U0 à U4 associés respectivement aux signaux e₀ à e₄ pour effectuer la charge et décharge d'une ligne commune L. Chaque module est contrôlé par l'un des signaux de sélection a0 à a4 et comporte un circuit de charge PC et un circuit de décharge DC commandés par le signal associé. Par exemple, le module U0 associé au signal de sélection a0 et au signal e₀ comporte un circuit de charge PC et un circuit de décharge DC constitué d'une résistance variable R0* ou R0 et de deux interrupteurs P0, SW0* ou N0, SW0 contrôlant la connexion par cette résistance de la ligne L au potentiel d'alimentation Vdd pour le circuit de charge et Vss pour le circuit de décharge. Les interrupteurs SW0 et SW0* sont commandés par le signal de sélection a0 du module U0. L'interrupteur N0 du circuit de décharge est commandé par le signal e₀ et l'interrupteur P0 est commandé par le complément e₀* de ce signal.

Les autres modules U1 à U4 sont identiques au module U0 mais ont leurs interrupteurs commandés par les signaux de sélection et les signaux retardés associés. D'autre part, les résistances variables R0, R0*, R2, R2*, R4, R4* des modules de rang pair sont commandées de façon à prendre une valeur inversement proportionnelle au coefficient K tandis que les résistances de rang impair R1, R1*, R3, R3* sont commandées de façon à prendre une valeur inversement proportionnelle à 1 - K. Le potentiel de la ligne L constitue la mesure du signal de combinaison f_{K}.

Pour expliquer le fonctionnement du circuit de la figure 7, nous supposerons que les deux premiers modules U0 et U1 sont sélectionnés et que la ligne L est chargée initialement au potentiel Vdd avec e₀ et e₁ à 0. Les interrupteurs P0 et P1 sont alors fermés tandis que les interrupteurs N0 et N1 sont ouverts.

Lorsque le signal e₀ devient actif, l'interrupteur N0 se ferme et l'interrupteur P0 s'ouvre. Le circuit présente alors une constante de temps défini par la capacité de structure au niveau de la ligne L et une résistance équivalente aux résistances R0 et R1* montées en parallèle. Comme R0 et R1* sont inversement proportionnelles à respectivement K et 1 -K, la constante de temps est indépendante de K. La ligne L va alors se décharger avec cette constante de temps depuis la valeur Vdd vers la valeur (1 - K) Vdd.

La décharge se poursuit de cette façon jusqu'à l'instant où le signal e₁ devient actif. Dès lors, l'interrupteur N1 se ferme et l'interrupteur P1 s'ouvre. La ligne L va alors continuer à se décharger vers 0 avec la même constante de temps que précédemment.

Lorsque le signal e₀ redevient inactif, l'interrupteur P0 se ferme et l'interrupteur N0 s'ouvre, ce qui rétablit un circuit de charge de la ligne L vers la tension K Vdd. Lorsque e₁ redevient inactif, on se retrouve dans la situation initiale.

On peut vérifier que le comportement du circuit de la figure 7 est identique du point de vue retard à celui de la réalisation ECL.

La figure 8 représente la réalisation CMOS détaillée d'un des modules de charge et décharge Ug du circuit de la figure 7. Les circuits de charge et de décharge sont constitués de transistors MOS respectivement à canal p et n. Les résistances variables sont réalisées au moyen de transistors MOS branchés en parallèle et commandés par les signaux k0 à k4 et k0* à k4*, les interrupteurs associés P0 ou N0 étant constitués par les chemins drain-source de transistors MOS respectivement à canal p et n dont les grilles reçoivent le signal associé eg. De même, les interrupteurs SW0 et SW0* sont constitués des chemins drain-source de transistors MOS à canal respectivement n et p dont les grilles reçoivent respectivement le signal de sélection ag et son complément ag*.

Le module représenté à la figure 8 est un module de rang pair où les commandes k0 à k4, k0* à k4* sont appliquées aux transistors MOS complémentaires de façon à ce que leur résistance équivalente soit inversement proportionnelle au coefficient K. Les modules de rang impair sont identiques à la différence près que les signaux k0 à k4 sont remplacés respectivement par k0* à k4* et réciproquement.

Les circuits à retard fixe D1 à D4 sont réalisés chacun au moyen de deux inverseurs CMOS en cascade.

La capacité de structure définissant la constante de temps est due aux capacités drain-grille des transistors MOS actifs reliés à la ligne L. De par la conception du circuit, la capacité résultante reste constante, indépendamment de la valeur de K.

D'autre part, les transistors MOS constituant les résistances variables de chaque circuit de charge ou de décharge peuvent être dimensionnés de façon à ce que leurs résistances varient selon une puissance de 2, selon les poids des signaux de commande de k0, ..., k4, ..., k0*, ..., k4*.

Une autre possibilité consiste à remplacer les transistors de dimensionnement variable par des montages parallèle et série de transistors identiques.

Le fonctionnement du circuit de la figure 8 est dans son principe identique à celui de la figure 7 et ne nécessite donc pas d'explications supplémentaires.

La figure 9 représente un mode de réalisation du circuit de commande 3 ainsi que des moyens pour produire la consigne de retard CN.

Selon cette réalisation, la consigne CN est une grandeur numérique binaire définie par l'état d'un compteur-décompteur 4 ayant par exemple une capacité de 8 bits c0 à c7. les poids forts c5 et c6 définissent la gamme de réglage tandis que les poids faibles c0 à c4 sont représentatifs du coefficient de pondération K. L'état du compteur 4 peut être incrémenté ou décrémenté respectivement en réponse aux signaux INC ou DEC. Les signaux INC et DEC sont appliqués respectivement aux entrées de mise à 1 et à 0 d'une bascule 6 dont la sortie est appliquée à l'entrée de commande d'incrémentation/décrémentation du compteur 4. Les signaux INC et DEC sont d'autre part appliqués aux entrées d'une porte OU 7 dont la sortie est reliée à l'entrée d'une porte ET 8 dont la seconde entrée reçoit un signal d'horloge CK. La sortie de la porte ET 8 est reliée à l'entrée d'horloge H du compteur 4.

Les signaux de commande k0 à k4 représentatifs du coefficient de pondération K sont fournis par des portes OU EXCLUSIF dont une première entrée reçoit le bit C5 du compteur 4 et dont la seconde entrée reçoit l'un des compléments c0* à c4* des bits de poids faible c0 à c4 du compteur 4.

Les signaux de sélection a0 à a4 sont fournis par un décodeur 5 des bits de poids fort c5, c6. Le décodeur 5 sera par exemple réalisé au moyen d'un circuit logique combinatoire conçu pour vérifier la table de vérité suivante :

| C6 | C5 | a0 | a1 | a2 | a3 | a4 |
|---|---|---|---|---|---|---|
| 0 | 0 | 1 | 1 | 0 | 0 | 0 |
| 0 | 1 | 0 | 1 | 1 | 0 | 0 |
| 1 | 0 | 0 | 0 | 1 | 1 | 0 |
| 1 | 1 | 0 | 0 | 0 | 1 | 1 |

Le fonctionnement du circuit de la figure 9 va maintenant être décrit à l'aide des diagrammes de la figure 10.

Les ordres de modification de l'état du compteur 4 apparaissent sous la forme de deux signaux INC et DEC commandant respectivement l'incrémentation et la décrémentation du compteur. La sortie de la porte OU 7 est donc représentative d'une demande de modification. Cette demande est synchronisée par un signal d'horloge CK au moyen de la porte ET 8 dont la sortie fournit le signal de synchronisation du compteur 4.

Lorsque le signal INC est à 1, la sortie Q de la bascule 6 prend la valeur 1, ce qui conditionne le compteur 4 à l'incrémentation qui sera effective à l'apparition du signal d'horloge CK. Inversement, lorsque DEC est à 1, la sortie Q est forçée à 0 et le compteur 4 est conditionné à la décrémentation.

La figure 10 (a) représente les variations de la grandeur numérique NK représentative du coefficient de pondération K et matérialisée par les signaux k0 à k4 fournis en sortie du circuit de commande 3. Grâce au montage, la variation de NK en fonction de CN change de sens lorsque c5 change de valeur binaire. Chacun des ces changements correspond au passage d'une gamme à une autre comme représenté sur la figure 10 (b) qui montre les variations du numéro de gamme NA en fonction de la consigne CN.

La figure 10 (c) représente les variations du retard global T_{KA} (mesuré à partir de l'instant tl défini précédemment) en fonction de la consigne CN. Pour chaque gamme, la plage de réglage est égale à la valeur du retard fixe correspondant. Ceci offre la possibilité de faire varier la pente de la courbe représentative du retard T_{KA} en fonction de CN selon la valeur de CN comme représentée sur la figure. Cette possibilité est intéressante à exploiter si l'on souhaite faire varier la précision du réglage en fonction de la valeur de la consigne CN. Ce sera le cas par exemple si le circuit utilisant le circuit à retard selon l'invention doit être prévu pour fonctionner à des fréquences très différentes.

## Revendications

1. Procédé pour fournir un signal de sortie (s_{K}) présentant un retard (Θ) par rapport à un signal logique d'entrée (e₀), ledit retard (Θ) étant réglable en fonction d'une consigne numérique de retard (CN), une succession de signaux retardés (e₁, e₂, ..., eₙ) par rapport au signal d'entrée (e₀) étant produite de façon à ce que le retard entre un signal retardé (e₂) et le signal précédent (e₁) ait une valeur prédéterminée, ledit procédé étant caractérié en ce qu'il consiste à sélectionner directement par les poids forts de ladite consigne numérique (CN) l'un desdits signaux retardés (e₂) et le signal précédent (e₁) et à effectuer une superposition avec pondération et effet intégral desdits signaux sélectionnés (e₁, e₂), ladite pondération étant déterminée en fonction des poids faibles de ladite consigne numérique (CN).

2. Procédé selon la revendication 1 caractérisé en ce que ladite pondération consiste à affecter aux deux signaux sélectionnés (e₁, e₂) respectivement deux coefficients de pondération complémentaire (K, 1 - K) fonction de ladite consigne de retard (CN) et compris entre 0 et une valeur maximale.

3. Procédé selon la revendication 2 caractérisé en ce que, pour une sélection initiale donnée d'un signal retardé (e₂) et du signal précédent (e₁), lorsque le coefficient de pondération du signal retardé (e₂) possède ladite valeur maximale alors que la consigne de retard augmente, ladite sélection est modifiée de façon à remplacer ledit signal précédent (e₁) par le signal (e₃) suivant ledit signal retardé (e₂) et en ce que, lorsque le coefficient de pondération du signal retardé (e2) est nul alors que la consigne de retard diminue, ladite sélection est modifiée de façon à remplacer ledit signal retardé (e₂) par le signal (e₀) précédant ledit signal précédent (e₁).

4. Circuit à retard pour fournir un signal de sortie (s_{K}) présentant un retard (Θ) par rapport à un signal logique d'entrée (e₀), ledit retard (Θ) étant réglable en fonction d'une consigne numérique de retard (CN), ledit circuit comportant une pluralité de circuits à retard fixe (D1, D2, Dn) montés en cascade, le premier desdits circuits à retard fixe (D1) recevant en entrée ledit signal d'entrée (e₀), lesdits circuits à retard fixe (D1, D2, ..., Dn) fournissant en sortie une succession de signaux retardés (e₁, e₂, ..., eₙ), des moyens de sélection (1) étant prévus pour sélectionner l'un desdits signaux retardés (e₂) et le signal précédent (e₁) et des moyens de combinaison (2) pour fournir un signal de combinaison (f_{K}) résultant de la superposition avec pondération et effet intégral desdits signaux sélectionnés (e₁, e₂), ledit circuit étant caractérisé en ce que lesdits moyens de sélection (1) et de combinaison (2) sont commandés par un circuit de commande (3) en fonction respectivement des poids forts et des poids faibles de ladite consigne numérique (CN).

5. Circuit à retard selon la revendication 4 caractérisé en ce que ladite pondération consiste à affecter aux deux signaux sélectionnés (e₁, e₂) respectivement deux coefficients de pondération complémentaires (K, 1 - K) fonction de ladite consigne numérique (CN) et compris entre 0 et une valeur maximale.

6. Circuit à retard selon la revendication 5 caractérisé en ce que ledit circuit de commande (3) produit des signaux de sélection (a0, a1, ..., a4) appliqués auxdits moyens de sélection (1) et lesdits premier et second coefficients de pondération (K, 1 - K), et en ce que, pour un signal retardé (e₂) et un signal précédent (e₁) sélectionnés, ledit circuit de commande affecte audit signal retardé (e₂) un coefficient de pondération (K, 1 - K) variant selon une fonction croissante de ladite consigne de retard (CN).

7. Circuit à retard selon la revendication 6 caractérisé en ce que lesdits moyens de combinaison (2) comportent une impédance commune (Z) et une première et une seconde source de courant (Sx, Sy) fournissant respectivement des courants (Ix, Iy) proportionnels auxdits premier et second coefficients de pondération (K, 1 - K), en ce que lesdits moyens de combinaison (2) comportent une pluralité de moyens interrupteurs (Q0, Q1, ..., Q4) commandés respectivement par ledit signal d'entrée (e₀) et lesdits signaux retardés (e₁, ..., e₄), en ce que lesdits moyens interrupteurs associés au signal d'entrée (e₀) et aux signaux retardés de rang pair (e₂, ..., e₄) sont disposés entre une borne de ladite impédance commune (Z) et la première source de courant (Sx) par l'intermédiaire desdits moyens de sélection (1), en ce que lesdits moyens interrupteurs associés aux signaux de rang impair (e₁, e₃) sont disposés entre une borne de ladite impédance commune (Z) et la seconde source de courant (Sy) par l'intermédiaire desdits moyens de sélection (1) et en ce que ledit premier coefficient de pondération (K) varie selon une fonction respectivement décroissante ou croissante de ladite consigne de retard (CN) selon que ledit signal retardé sélectionné est de rang respectivement impair ou pair.

8. Circuit à retard selon la revendication 6 caractérisé en ce que ledit signal d'entrée (e₀, e₀*) et lesdits signaux retardés (e₁, e₁*, ..., eₙ, eₙ*) sont des signaux différentiels, en ce que lesdits moyens de combinaison (2) comportent une première et une seconde résistance (R, R*) ayant chacune une première borne reliée à un potentiel d'alimentation (Vdd), en ce que lesdits moyens de combinaison (2) comportent une première et une seconde source de courant fournissant respectivement des courants (Ix, Iy) proportionnels auxdits premier et second coefficients de pondération (K, 1 - K) ainsi qu'une pluralité de montages différentiels associés respectivement au signal d'entrée (e₀, e₀*) et aux signaux retardés (e₁, e₁* ..., eₙ, eₙ*), chaque montage différentiel (M0, M1, M2) étant formé de deux transistors bipolaires (Q0, Q0*, ..., Q2, Q2*) dont les collecteurs sont reliés respectivement à la deuxième borne desdites première et seconde résistances (R, R*) et dont les bases reçoivent les signaux différentiels associés (e₀, e₀*, ..., e₂, e₂*), en ce que les émetteurs des transistors (Q0, Q0*, ..., Q2, Q2*) des montages différentiels (M0, M2) associés au signal d'entrée (e₀, e₀*) et aux signaux retardés de rang pair (e₂, e₂*) sont reliés à ladite première source de courant, en ce que les émetteurs des transistors (Q1, Q1*) des montages différentiels (M1) associés aux signaux retardés de rang impair (e₁, e₁*) sont reliés à ladite seconde source de courant et en ce que ledit premier coefficient de pondération (K) varie selon une fonction respectivement décroissante ou croissante de ladite consigne de retard (CN) selon que ledit signal retardé sélectionné est de rang respectivement impair ou pair.

9. Circuit à retard selon la revendication 6 caractérisé en ce que lesdits moyens de combinaison (2) comportent une pluralité de modules de charge et décharge (U0, U1, ..., U4) d'une ligne commune (L) commandés respectivement par le signal d'entrée (e₀) et les signaux retardés (e₁, ..., e₄), le potentiel de ladite ligne commune (L) constituant la mesure dudit signal de combinaison (f_{K}), en ce que chaque module (U0, U1, ..., U4) comporte respectivement un circuit de décharge (DC) et un circuit de charge (PC) comportant chacun des premier et second moyens interrupteurs (P0, N0, SW0, ..., P4, N4, SW4) contrôlant la connexion entre ladite ligne commune (L) et respectivement un premier et un second potentiel d'alimentation (Vss, Vdd) par l'intermédiaire d'une résistance variable, la résistance variable des circuits de décharge (DC) et de charge (PC) des modules (U0, U4) associés au signal d'entrée (e₀) et aux signaux retardés (e₂, ..., e₄) de rang pair étant commandée de façon à prendre une valeur inversement proportionnelle audit premier coefficient de pondération (K), la résistance variable des circuits de décharge (DC) et de charge (PC) des modules (U1, ..., U3) associés aux signaux retardés (e₁, e₃) de rang impair étant commandés de façon à prendre une valeur inversement proportionnelle audit second coefficient de pondération (1 - K), en ce que lesdits premiers moyens interrupteurs (P0, N0, ..., P4, N4) du circuit de décharge (DC) et du circuit de charge (PC) de chaque module (U0, ..., U4) sont activés respectivement par un premier et un second niveau de tension du signal associé (e₀, ..., e₄), en ce que l'ensemble desdits seconds moyens interrupteurs (SW0, ..., SW4) constitue lesdits moyens de sélection (1) et en ce que ledit premier coefficient de pondération (K) varie selon une fonction respectivement décroissante ou croissante de ladite consigne de retard (CN) selon que ledit signal retardé sélectionné est de rang respectivement impair ou pair.

## Patentansprüche

1. Verfahren zum Liefern eines Ausgangssignals (s_{K}), das eine Verzögerung (Θ) in bezug auf ein logisches Eingangssignal (e₀) aufweist, wobei die Verzögerung (Θ) in Abhängigkeit von einem digitalen Sollverzögerungswert (CN) einstellbar ist, wobei eine Folge von in bezug auf das Eingangssignal (e₀) verzögerten Signalen (e₁, e₂, ... eₙ) in der Weise erzeugt wird, daß die Verzögerung zwischen einem verzögerten Signal (e₂) und dem vorhergehenden Signal (e₁) einen vorgegebenen Wert besitzt, wobei das Verfahren dadurch gekennzeichnet ist, daß es darin besteht, durch die hochwertigen Stellen des digitalen Sollwerts (CN) direkt eines der verzögerten Signale (e₂) und das vorhergehende Signal (e₁) zu wählen und eine Überlagerung mit Gewichtung und Integralwirkung der gewählten Signale (e₁, e₂) auszuführen, wobei die Gewichtung in Abhängigkeit von den niederwertigen Stellen des digitalen Sollwerts (CN) bestimmt wird.

2. Verfahren nach Anspruch 1, dadurch gekennzeichnet, daß die Gewichtung darin besteht, den zwei gewählten Signalen (e₁, e₂) entsprechend zwei komplementäre Gewichtungskoeffizienten (K, 1 - K) zuzuweisen, die vom Verzögerungssollwert (CN) abhängen und im Bereich zwischen Null und einem Maximalwert enthalten sind.

3. Verfahren nach Anspruch 2, dadurch gekennzeichnet, daß für eine gegebene anfängliche Wahl eines verzögerten Signals (e₂) und des vorhergehenden Signals (e₁) dann, wenn der Gewichtungskoeffizient des verzögerten Signals (e₂) den Maximalwert besitzt und der Verzögerungssollwert ansteigt, die Wahl in der Weise modifiziert wird, daß das vorhergehende Signal (e₁) durch das dem verzögerten Signal (e₂) folgende Signal (e₃) ersetzt wird und daß dann, wenn der Gewichtungskoeffizient des verzögerten Signals (e₂) Null ist und der Verzögerungssollwert abnimmt, die Wahl in der Weise modifiziert wird, daß das verzögerte Signal (e₂) durch das dem vorhergehenden Signal (e₁) vorhergehende Signal (e₀) ersetzt wird.

4. Verzögerungsschaltung zum Liefern eines Ausgangssignals (s_{K}), das eine Verzögerung (Θ) in bezug auf ein logisches Eingangssignal (e₀) aufweist, wobei die Verzögerung (Θ) in Abhängigkeit von einem digitalen Verzögerungssollwert (CN) einstellbar ist, wobei die Schaltung mehrere Schaltungen mit fester Verzögerung (D1, D2, ..., Dn) enthält, die in Kaskade geschaltet sind, wobei die erste dieser Schaltungen mit fester Verzögerung (D1) am Eingang das Eingangssignal (e₀) empfängt, wobei die Schaltungen mit fester Verzögerung (D1, D2, ..., Dn) am Ausgang eine Folge von verzögerten Signalen (e₁, e₂, ..., eₙ) liefern, wobei Wählmittel (1) zum Wählen eines der verzögerten Signale (e₂) und des vorhergehenden Signals (e₁) sowie Kombinationsmittel (2) zum Liefern eines sich aus der Überlagerung mit Gewichtung und Integralwirkung der gewählten Signale (e₁, e₂) ergebenden Kombinationssignals (f_{K}) vorgesehen sind wobei die Schaltung dadurch gekennzeichnet ist, daß die Wählmittel (1) und die Kombinationsmittel (2) durch eine Steuerschaltung (3) in Abhängigkeit von den hochwertigen Stellen bzw. von den niederwertigen Stellen des digitalen Sollwerts (CN) gesteuert werden.

5. Verzögerungsschaltung nach Anspruch 4, dadurch gekennzeichnet, daß die Gewichtung darin besteht, den zwei gewählten Signalen (e₁, e₂) entsprechend zwei komplementäre Gewichtungskoeffizienten (K, 1 - K) zuzuweisen, die vom digitalen Sollwert (CN) abhängen und im Bereich zwischen Null und einem Maximalwert enthalten sind.

6. Verzögerungsschaltung nach Anspruch 5, dadurch gekennzeichnet, daß die Steuerschaltung (3) Wählsignale (a0, a1, ... a4), die an die Wählmittel (1) angelegt werden, sowie den ersten und den zweiten Gewichtungskoeffizienten (K, 1 - K) erzeugt, und daß die Steuerschaltung für ein gewähltes Verzögerungssignal (e₂) und ein gewähltes vorhergehendes Signal (e₁) dem verzögerten Signal (e₂) einen Gewichtungskoeffizienten (K, 1 - K) zuweist, der sich gemäß einer mit dem Verzögerungssollwert (CN) wachsenden Funktion verändert.

7. Verzögerungsschaltung nach Anspruch 6, dadurch gekennzeichnet, daß die Kombinationsmittel (2) eine gemeinsame Impedanz (Z) sowie eine erste und eine zweite Stromquelle (Sx, Sy) enthalten, die Ströme (Ix, Iy) liefern, die zum ersten bzw. zum zweiten Gewichtungskoeffizienten (K, 1 - K) proportional sind, daß die Kombinationsmittel (2) mehrere Einschalt/Ausschaltmittel (Q0, Q1, ... Q4) enthalten, die vom Eingangssignal (e₀) bzw. von den verzögerten Signalen (e₁, ..., e₄) gesteuert werden, daß die Einschalt-/Ausschaltmittel, die dem Eingangssignal (e₀) und den verzögerten Signalen mit gerader Ordnungszahl (e₂, ..., e₄) zugeordnet sind, zwischen einem Anschluß der gemeinsamen Impedanz (Z) und der ersten Stromquelle (Sx) über die Wählmittel (1) angeordnet sind, daß die Einschalt-/Ausschaltmittel, die den Signalen mit ungerader Ordnungszahl (e₁, e₃) zugeordnet sind, zwischen einem Anschluß der gemeinsamen Impedanz (Z) und der zweiten Stromquelle (Sy) über die Wählmittel (1) angeordnet sind und daß sich der erste Gewichtungskoeffizient (K) gemäß einer fallenden bzw. wachsenden Funktion des Verzögerungssollwerts (CN) verändert, je nachdem, ob das gewählte verzögerte Signal eine ungerade oder eine gerade Ordnungszahl besitzt.

8. Verzögerungsschaltung nach Anspruch 6, dadurch gekennzeichnet, daß das Eingangssignal (e₀, e₀*) und die verzögerten Signale (e₁, e₁*, ..., eₙ, eₙ*) differentielle Signale sind, daß die Kombinationsmittel (2) einen ersten und einen zweiten Widerstand (R, R*) enthalten, wovon jeder mit einem ersten Anschluß an ein Versorgungspotential (Vdd) angeschlossen ist, daß die Kombinationsmittel (2) eine erste und eine zweite Stromquelle, die Ströme (Ix, Iy) liefern, die zum ersten bzw. zum zweiten Gewichtungskoeffizienten (K, 1 - K) proportional sind, sowie mehrere differentielle Schaltungen enthalten, die dem Eingangssignal (e₀, e₀*) bzw. den verzögerten Signalen (e₁, e₁*, ..., eₙ, eₙ*) zugeordnet sind, wobei jede differentielle Schaltung (M0, M1, M2) aus zwei Bipolartransistoren (Q0, Q0*, ..., Q2, Q2*) gebildet ist, deren Kollektoren mit dem zweiten Anschluß des ersten bzw. des zweiten Widerstandes (R, R*) verbunden sind und deren Basen die zugeordneten differentiellen Signale (e₀, e₀*, ..., e₂, e₂*) empfangen, daß die Emitter der Transistoren (Q0, Q0*, ..., Q2, Q2*) der differentiellen Schaltungen (M0, M2), die dem Eingangssignal (e₀, e₀*) und den verzögerten Signalen mit gerader Ordnungszahl (e₂, e₂*) zugeordnet sind, mit der ersten Stromquelle verbunden sind, daß die Emitter der Transistoren (Q1, Q1*) der differentiellen Schaltungen (M1), die den verzögerten Signalen mit ungerader Ordnungszahl (e₁, e₁*) zugeordnet sind, mit der zweiten Stromquelle verbunden sind und daß sich der erste Gewichtungskoeffizient (K) gemäß einer fallenden bzw. wachsenden Funktion des Verzögerungssollwerts (CN) verändert, je nachdem, ob das gewählte verzögerte Signal eine ungerade oder eine gerade Ordnungszahl besitzt.

9. Verzögerungsschaltung nach Anspruch 6, dadurch gekennzeichnet, daß die Kombinationsmittel (2) mehrere Module zum Laden und Entladen (U0, U1, ..., U4) einer gemeinsamen Leitung, (L) besitzen, die vom Eingangssignal (e₀) bzw. von den verzögerten Signalen (e₁, ..., e₄) gesteuert werden, wobei das Potential der gemeinsamen Leitung (L) das Maß für das Kombinationssignal (f_{K}) bildet, daß jedes Modul (U0, U1, ..., U4) eine Entladeschaltung (DC) bzw. eine Ladeschaltung (PC) enthält, die jeweils erste und zweite Einschalt-/Ausschaltmittel (P0, N0, SW0, ..., P4, N4, SW4) enthalten, die die Verbindung zwischen der gemeinsamen Leitung (L) und einem ersten bzw. einem zweiten Versorgungspotential (Vss, Vdd) über einen veränderlichen Widerstand steuern, wobei der veränderliche Widerstand der Entladeschaltungen (DC) und der Ladeschaltungen (PC) der Module (U0, ..., U4), die dem Eingangssignal (e₀) und den verzögerten Signalen (e₂, ..., e₄) mit gerader Ordnungszahl zugeordnet sind, in der Weise gesteuert wird, daß er einen zum ersten Gewichtungskoeffizient (K) umgekehrt proportionalen Wert annimmt, wobei der veränderliche Widerstand der Entladeschaltungen (DC) und der Ladeschaltungen (PC) der Module (U1, ..., U3), die den verzögerten Signalen (e₁, e₃) mit ungerader Ordnungszahl zugeordnet sind, in der Weise gesteuert wird, daß er einen zum zweiten Gewichtungskoeffizienten (1 - K) umgekehrt proportionalen Wert annimmt, daß die ersten Einschalt-/Ausschaltmittel (P0, N0, ..., P4, N4) der Entladeschaltung (DC) und der Ladeschaltung (PC) jedes Moduls (U0, ..., U4) durch einen ersten bzw. einen zweiten Spannungspegel des zugeordneten Signals (e₀, ..., e₄) aktiviert werden, daß die Gesamtheit der zweiten Einschalt-/Ausschaltmittel (SW0, ..., SW4) die Wählmittel (1) bildet und daß sich der erste Gewichtungskoeffizient (K) gemäß einer fallenden bzw. wachsenden Funktion des Verzögerungssollwerts (CN) verändert, je nachdem, ob das gewählte verzögerte Signal eine ungerade oder eine gerade Ordnungszahl besitzt.

## Claims

1. A process for supplying an output signal (S_{K}) having a delay (θ) relative to an input logic signal (eₒ), said delay (θ) being adjustable as a function of a digital delay set-point (CN), a succession of signals (e₁, e₂, ..., eₙ) delayed relative to the input signal (eₒ) being produced so that the delay between a delayed signal (e₂) and the preceding signal (e₁) has a predetermined value, said process being characterised in that it consists in directly selecting, through the most significant bits of said digital set-point (CN), one of said delayed signals (e₂) and the preceding signal (e₁) and in performing the superimposition with weighting and integration of said selected signals (e₁, e₂), said weighting being determined as a function of the least significant bits of said digital set-point (CN).

2. A process according to Claim 1 characterised in that said weighting consists in assigning two complementary weighting coefficients (K, 1-K) to the two selected signals (e₁, e₂) respectively as a function of said delay set-point (CN) and between 0 and a maximum value inclusive.

3. A process according to Claim 2 characterised in that, for a given initial selection of a delayed signal (e₂) and of the preceding signal (e₁), if the weighting coefficient of the delayed signal (e₂) assumes said maximum value whereas the delay set-point increases, said selection is modified so as to replace said preceding signal (e₁) by the signal (e₃) that follows said delayed signal (e₂) and in that, if the weighting coefficient of the delayed signal (e₂) is zero whereas the delay set-point decreases, said selection is modified so as to replace said delayed signal (e₂) by the signal (eₒ) that precedes said preceding signal (e₁).

4. A delay circuit for supplying an output signal (S_{K}) having a delay (θ) relative to an input logic signal (eₒ), said delay (θ) being adjustable as a function of a digital delay set-point (CN), said circuit comprising a plurality of fixed-delay circuits (D1, D2, ..., Dn) which are cascade connected, said input signal (eₒ) being applied to the input of the first of said fixed-delay circuits (D1), said fixed-delay circuits (D1, D2, ..., Dn) outputting a succession of delayed signals (e₁, e₂, ..., eₙ), selection means (1) being provided to select one of said delayed signals (e₂) and the preceding signal (e₁) and combination means (2) to deliver a combined signal (f_{K}) resulting from the superimposition with weighting and integration of said selected signals (e₁, e₂), said circuit being characterised in that said selection means (1) and combination means (2) are controlled by a control circuit (3) as a function respectively of the most significant bits and the least significant bits of said digital set-point (CN).

5. A delay circuit according to Claim 4 characterised in that said weighting consists in assigning two complementary weighting coefficients (K, 1-K) to the two selected signals (e₁, e₂) respectively, as a function of said digital set-point (CN) and between 0 and a maximum value inclusive.

6. A delay circuit according to Claim 5 characterised in that said control circuit (3) produces selection signals (aO, a1, ..., a4) applied to said selection means (1) and said first and second weighting coefficients (K, 1-K) and in that, for a delayed signal (e₂)and a preceding signal (e₁) that have been selected, said control circuit assigns to said delayed signal (e₂) a weighting coefficient (K, 1-K) that varies in accordance with an increasing function of said delay set-point (CN).

7. A delay circuit according to Claim 6 characterised in that said combination means (2) comprise a common impedance (Z) and a first and a second power source (Sx, Sy) delivering currents (lx, ly) respectively that are proportional to said first and second weighting coefficients (K, 1-K) and in that said combination means (2) comprise a plurality of switching means (Q0, Q1, ..., Q4) controlled respectively by said input signal (e₀) and said delayed signals (e₁, ..., e₄) and in that said switching means associated with the input signal (eₒ) and with the even-order delayed signals (e₂, ..., e₄) are disposed between a terminal of said common impedance (Z) and the first power source (Sx) via said selection means (1), in that said switching means associated with the odd-order signals (e₁, e₃) are disposed between a terminal of said common impedance (Z) and the second power source (Sy) via said selection means (1) and in that said first weighting coefficient (K) varies in accordance with a respectively decreasing or increasing function of said delay set-point (CN) depending whether said selected delayed signal is an odd or even-order signal respectively.

8. A delay circuit according to Claim 6 characterised in that said input signal (eₒ, eₒ*) and said delayed signals (e₁, e₁*, ..., eₙ, eₙ*) are differential signals, in that said combination means (2) comprise a first and a second resistor (R, R*) each having a first terminal connected to a power supply potential (Vdd), and in that said combination means (2) comprise a first and a second power source delivering currents (lx, ly) respectively that are proportional to said first and second weighting coefficients (K, I-K) as well as a plurality of differential circuits associated respectively with the input signal (eₒ, eₒ*) and the delayed signals (e₁, e₁*, ..., eₙ, eₙ*), each differential circuit (MO, M1, M2) being formed by two bipolar transistors (Q0, QO*, ..., Q2, Q2*) the collectors of which are respectively connected to the second terminal of said first and second resistors (R, R*) and the bases of which receive the associated differential signals (eₒ, eₒ*, ..., e₂, e₂*) and in that the emitters of the transistors (Q0, QO*, ..., Q2, Q2*) in the differential circuits (MO, M2) associated with the input signal (eₒ, eₒ*) and the even-order delayed signals (e₂, e₂*) are connected to said first power source and in that the emitters of the transistors (Q1, Q1*) in the differential circuits (M1) associated with the odd-order delayed signals (e₁, e₁*) are connected to said second power source and in that said first weighting coefficient (K) varies in accordance with a decreasing or increasing function of said delay set-point (CN) depending whether said delayed signal selected is odd or even-order respectively.

9. A delay circuit according to Claim 6 characterised in that said combination means (2) comprise a plurality of modules for charging and discharging (U0, U1, ..., U4) a common line (L) controlled respectively by the input signal (eₒ) and the delayed signals (e₁, ..., e₄), the potential of said common line (L) constituting a measure of said combination signal (f_{K}), in that each module (U0, U1, ..., U4) comprises a discharging circuit (DC) and a charging circuit (PC) respectively, each comprising first and second switching means (P0, NO, SWO, ..., P4, N4, SW4) that control the connection between said common line (L) and a first and a second power supply potential (Vss, Vdd) respectively, via a variable resistance, the variable resistance of the discharging (DC) and charging (PC) circuits of the modules (U0, ..., U4) associated with the input signal (eₒ) and the delayed signals (e₂, ..., e₄) of even-order being controlled so as to take a value that is inversely proportional to said first weighting coefficient (K), the variable resistance of the discharging (DC) and charging (PC) circuits of the modules (U1, ..., U3) associated with the delayed signals (e₁, e₃) of odd-order being controlled so as to take a value that is inversely proportional to said second weighting coefficient (1-K), in that said first switching means (PO, NO, ..., P4, N4) of the discharging circuit (DC) and of the charging circuit (PC) of each module (U0, ..., U4) are activated respectively by a first and a second voltage level of the associated signal (eₒ, ..., e₄), in that all said second switching means (SWO, ..., SW4) constitute said selection means (1) and in that said first weighting coefficient (K) varies in accordance with a respectively decreasing or increasing function of said delay set-point (CN) depending whether said delayed signal selected is odd or even-order respectively.
